# EUROPÄISCHE PATENTSCHRIFT

(11) **EP 1 228 677 B1**
(45) Veröffentlichungstag und Bekanntmachung des Hinweises auf die Patenterteilung: **02.05.2003**
(21) Anmeldenummer: 00984882.1
(22) Anmeldetag: 08.11.2000
(51) Int. Cl.: H05K 13/04

(54) **EINRICHTUNG ZUM HALTEN EINES GREIFERS FÜR EIN ELEKTRISCHES BAUELEMENT AN EINEM BESTÜCKKOPF**
DEVICE FOR HOLDING A GRIPPER FOR AN ELECTRICAL COMPONENT ON A FITTING HEAD
DISPOSITIF DESTINE A MAINTENIR UN ELEMENT PREHENSEUR CONCU POUR UN COMPOSANT ELECTRIQUE SUR UNE TETE A EQUIPER

(30) Priorität: 09.11.1999 DE 19953880
(43) Veröffentlichungstag der Anmeldung: 07.08.2002
(73) Patentinhaber: SIEMENS AKTIENGESELLSCHAFT, 80333 München (DE)
(72) Erfinder: REIMANN, Günter, 81375 München (DE)
(86) Internationale Anmeldenummer: DE0003905
(87) Internationale Veröffentlichungsnummer: WO01035711

(56) Entgegenhaltungen:
- JP-A- 6 196 896
- JP-A- 6 335 888
- US-A- 5 807 221

## Beschreibung

Die Erfindung bezieht sich auf eine Einrichtung zum Halten eines Greifers für ein elektrisches Bauelement an einem Bestückkopf, wobei der Greifer an einem Endabschnitt eines im wesentlichen zylindrischen Schafts des Bestückkopfes lösbar befestigbar ist.

Bisher war es üblich, als Saugpipetten ausgebildete Greifer mit einem hohlzylindrischen Zentrierabschnitt auf einen zylindrischen Endabschnitts eines drehbaren Schafts des Bestückkopfes aufzustecken. Auf der Innenseite des Buchsenabschnittes ist eine flache ringförmige Rastnut eingelassen. In eine nach außen offene Ringnut des Schafts war ein elastomerer O-Ring eingesetzt, der unter Spannung in die Rastnut eingreift. Die Ringnut und die Rastnut sind axial so weit versetzt, daß der Greifer in axialer Richtung gegen einen Anschlag des Schafts gedrückt wird, wodurch die Greiferachse und die Schaftachse zueinander parallel ausgerichtet werden. Ein kurzer Zentrierabschnitt des Greifers legt sich in enger Passung an einen entsprechenden zylindrischen Abschnitt des Schafts an, wodurch der Greifer in radialer Richtung am Schaft zentriert wird.

Bei einer Winkelabweichung der Pipettenachse von der Schaftachse wird der Rundlauf der Pipettenspitze mit einem daran gehaltenen Bauelement beeinträchtigt. Das Bauelement muß vor dem Aufsetzen auf eine Leiterplatte aus einer Abhollage in eine Aufsetzlage verdreht werden, wobei es zu einem entsprechenden Seitenversatz kommen kann. Eine Exzentrizität der Pipettenspitze kann insbesondere bei sehr kleinen Bauelementen dazu führen, daß sie exzentrisch angesaugt werden und in den Saugkanal hineingezogen werden und die pneumatischen Funktionen des Bestückkopfes stören.

Der O-Ring weist relativ große Fertigungstoleranzen auf, die dazu führen, daß die Aufsteck- und Abzugskräfte in einem weiten Bereich variieren. Da die Greifer in Abhängigkeit von den zu greifenden Bauelementen relativ häufig gewechselt werden müssen, muß der O-Ring mit erheblichem Wartungsaufwand häufig und sorgfältig nachgefettet werden, um einen entsprechend hohen Reibungsverschleiß zu vermeiden. Selbst der sorgfältig gewartete O-Ring unterliegt einem Restverschleiß, der einen periodischen Austausch bedingt. Da die Wechselhäufigkeit der einzelnen Pipetten automatisch nicht zu überwachen ist, ist es auch entsprechend schwierig, die Wartungsintervalle so abzustimmen, daß die Andrückfunktion jederzeit sicher erfüllt wird, so daß eine Winkelabweichung zwischen den Achsen des Schaftes und der Saugpipette nicht immer vermieden werden kann.

Durch die JP 2067799 A ist eine Halteeinrichtung zum Fixieren einer Saugpipette an einem Bestückkopf bekannt geworden, der eine hohlzylindrischen Zentrierbuchse aufweist, in die ein konvexzylindrischer Verbindungszapfen der Saugpipette einsetzbar ist. Der Verbindungszapfen weist eine Ringnut auf, in die radial auslenkbare Rastkugeln des Bestückkopfes eingreifen, die beim Pipettenwechsel durch Zurückschieben einer Spannbuchse freigegeben werden. Eine derartige aktive Verrastung bedarf eines relativ großen mechanischen Aufwands, bei einem entsprechnd großen Außendurchmesser im Bereich des Halteabschnitts. Die erforderliche Schlankheit der Pipette kann nur durch eine ein entsprechende Verlängerung derselben erreicht werden, durch die allerdings die Pipettenspitze vom Halteabschnitt weiter entfernt ist, wodurch sich ihre Lagegenauigkeit verringert.

Der Erfindung liegt die Aufgabe zugrunde, eine sichere und genaue Fixierung des Greifers am Schaft bei geringem Herstell- und Wartungsaufwand zu ermöglichen.

Diese Aufgabe wird durch die Erfindung gemäß Anspruch 1 gelöst. Die Rastkuppen können in einer genau definierten Lage und Bemessung am Schaft angeordnet werden. Sie können eine abriebfeste und glatte Oberfläche aufweisen, die einem geringen Verschleiß unterliegt. Die Tiefe der Rastnut ist so gering, daß die erforderliche wechselseitige Auslenkung im Bereich der elastischen Nachgiebigkeit liegt. Insbesondere läßt sich der axiale Versatz zwischen der Rastnut und den Rastkuppen auf ein genaues Maß festlegen, so daß die axialen Andrückkräfte erheblich genauer eingegrenzt werden können. Die Aufsteck- und Abziehkräfte können ebenfalls auf einen engeren Toleranzbereich begrenzt werden, wodurch die mittlere Betätigungskraft reduziert werden kann.

Vorteilhafte Weiterbildungen der Erfindung sind in den Unteransprüchen gekennzeichnet:
Die Rastkuppen nach Anspruch 2 ergeben punktartige Anlagen zwischen dem Schaft und dem Greifer, was die wechselseitige Auslenkung beim Einrasten begünstigt.
Die Ringnut nach Anspruch 3 läßt sich genau konzentrisch zum zylindrischen Zentrierabschnitt ausbilden, so daß die Metallkugeln in ihrer radialen Einbaulage genau angeordnet werden können.
Die Rastkugeln nach Anspruch 4 sind als Normteile von hoher Genauigkeit und hoher Festigkeit und guten Gleiteigenschaften kostengünstig erhältlich. Durch das Ausgießen der gesamten Ringnut werden die Kugeln fest mit dem Schaft verbunden.
Das Gießmaterial nach Anspruch 5 ist von so zäher Konsistenz, daß es ohne weitere Hilfsmittel vor dem Aushärten in der Ringnut haftet. In dieses Material können die Rastkugeln durch einfaches Eindrücken eingesetzt werden.

Durch die Ausgestaltung nach Anspruch 6 ist die Greiferwand aus ihrer Zylinderform heraus so weit biegbar, daß eine hinreichende Nachgiebigkeit beim Einrasten ohne bleibende Verformung erreicht werden kann. Besonders günstig ist es hierbei, wenn in der Ringnut zwischen drei und fünf Kugeln verteilt sind. Dies ergibt eine sichere Zentrierung mit hinreichender Nachgiebigkeit.

Im folgenden wird die Erfindung anhand eines in der Zeichnung dargestellten Ausführungsbeispieles näher erläutert.
- Figur 1: zeigt einen Längsschnitt durch einen Bestückkopf mit einem Schaft und einem Greifer,
- Figur 2: einen Querschnitt entlang der Linie II-II in Figur 1,
- Figur 3: einen vergrößerten Ausschnitt durch die Teile nach Figur 1 im Bereich des Schnitts der Figur 2.

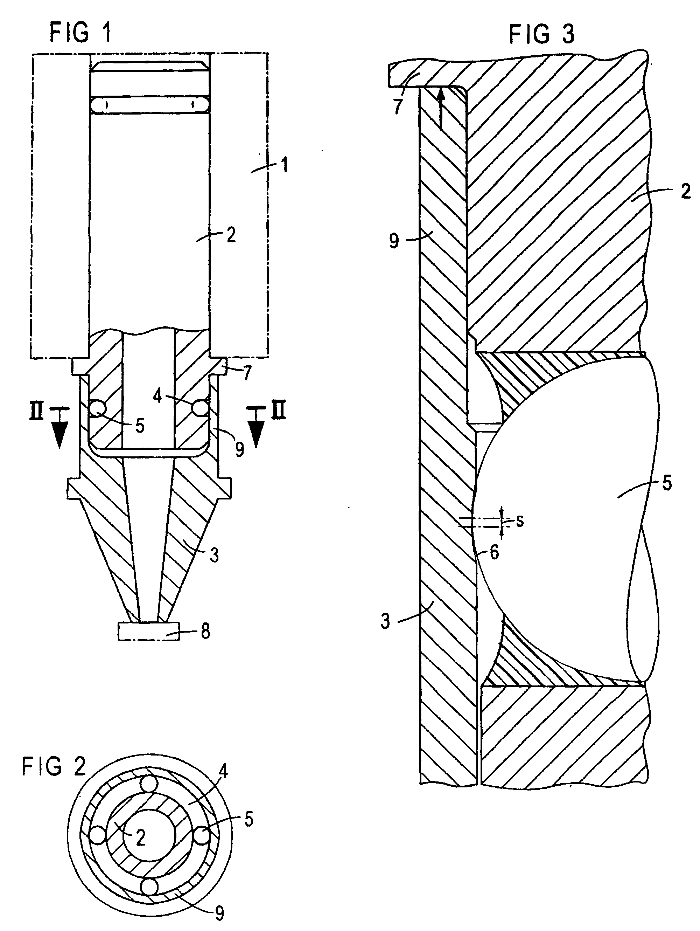

Nach den Figuren 1, 2 und 3 ist ein verfahrbarer Greifer 1 für ein elektrisches Bauelement 8 mit einem senkrechten, im wesentlichen zylindrischen Schaft 2 versehen, an dessen unterem Ende ein als Saugpipette ausgebildeter Greifer 3 austauschbar gehalten ist, der mit einem dünnwandigen Buchsenabschnitt auf das untere Ende des Schafts 2 aufgesteckt ist. In diesen ist eine Ringnut 4 eingelassen, deren Tiefe etwas geringer ist als der Durchmesser von in der Ringnut 4 umlaufend verteilten Rastkugeln 5. Der innere Teil der Ringnut ist in ihrem Querschnitt abgerundet und von etwas größerem Radius als die Rastkugeln, wodurch eine sichere Anlage im Nutgrund möglich ist.

Nach Figur 3 ist in der Innenwand des Buchsenabschnitts des Greifers 3 in der Höhe der Ringnut eine umlaufende Rastnut 6 ausgebildet, in die die Rastkugeln 5 mit ihren äußeren Kuppen eingreifen. Die Ringnut ist in axialer Richtung zur Rastnut um den Betrag s so weit versetzt, daß die obere Stirnseite des Greifers 3 gegen einen umlaufenden kragenförmigen Anschlag 7 des Schafts 2 gedrückt wird. Zwischen dem Anschlag 7 und der Ringnut 4 erstreckt sich ein Zentrierabschnitt 9, in dem die Innenwand des Greifers 3 den Schaft 2 spielfrei umgreift, so daß dieser gegenüber der Schaftachse genau zentriert ist. Durch den axialen Andruck an den Anschlag 7 wird der Greifer 3 gegenüber dem Schaft 2 in seiner Winkellage gesichert, so daß die Greiferachse und die Schaftachse genau aufeinander ausgerichtet werden können.

Diese zu greifenden Bauelemente werden an die untere Stirnseite des Greifers 3 angesaugt. Sodann wird das Bauelement mittels einer Kamera in seiner relativen Lage zur Greiferspitze vermessen und dann entsprechend den Meßwerten verdreht. Bei einer Abweichung der Greiferachse zur Schaftachse kommt es zu einer entsprechenden Lageverschiebung, die die Aufsetzgenauigkeit verringert. Durch die genaue Lagerung des Greifers 3 am Schaft 2 wird diese Abweichung auf ein Minimum verringert.

### Bezugszeichen

- 1: Bestückkopf
- 2: Schaft
- 3: Greifer
- 4: Ringnut
- 5: Rastkugel
- 6: Rastnut
- 7: Anschlag
- 8: Bauelement
- 9: Zentrierabschnitt

## Patentansprüche

1. Einrichtung zum Halten eines Greifers (3) für ein elektrisches Bauelement (8) an einem Bestückkopf (1),
wobei der Greifer (3) an einem Endabschnitt eines im wesentlichen zylindrischen Schafts (2) des Bestückkopfes (1) lösbar befestigbar ist,
wobei der Greifer (3) in axialer Richtung auf den Schaft (2) aufsteckbar ist,
wobei der Greifer (3) im Bereich des Schafts (2) einen an diesem anliegenden hohlzylindrischen Zentrierabschnitt (9) aufweist,
wobei der Greifer im Bereich des Zentrierabschnittes (9) oder nahe bei diesem eine ringförmige Rastnut (6) aufweist,
wobei der Schaft (2) mit in die Rastnut (6) eingreifenden, radial überstehenden Rastmitteln (5) versehen ist und
wobei die Rastmittel zur Rastnut (6) axial derart versetzt sind, daß der Greifer (3) in axialer Richtung gegen einen Anschlag (7) des Schafts (2) drückbar ist,
**dadurch gekennzeichnet, daß** die Rastmittel als umlaufend verteilte feste kurze Rastkuppen ausgebildet sind, die fest mit dem Schaft (2) verbunden sind und in die flache Rastnut (6) eingreifen.

2. Einrichtung nach Anspruch 1,
**dadurch gekennzeichnet, daß** die Rastkuppen als Kugelkalotten ausgebildet sind.

3. Einrichtung nach Anspruch 2,
**dadurch gekennzeichnet, daß** die Rastkuppen an metallischen Rastkugeln (5) ausgebildet sind, die in eine Ringnut (4) des Schafts (2) eingesetzt und darin zum Beispiel durch Kleben befestigt sind.

4. Einrichtung nach Anspruch 3,
**dadurch gekennzeichnet, daß** die Rastkugeln (5) als Stahlkugeln für Kugellager ausgebildet sind und in der Ringnut (4) durch Vergießen befestigt sind.

5. Einrichtung nach Anspruch 4,
**dadurch gekennzeichnet, daß** die Ringnut (4) mit einem Dichtmaterial in der Art von Silikongummi ausgegossen ist.

6. Einrichtung nach einem der vorhergehenden Ansprüche,
**dadurch gekennzeichnet, daß** der Greifer in einem Befestigungsbereich eine buchsenartige Ringwand (9) aufweist, die den Schaft (2) von außen umgreift und daß die Wandstärke der Ringwand (9) so gering ist, daß sich diese unter der Spannung der Rastkuppen zu einem Rundeck deformiert.

## Claims

1. Device for holding a gripper (3) for an electrical component (8) on a fitting head (1),
it being possible for the gripper (3) to be fixed detachably to an end section of a substantially cylindrical shaft (2) of the fitting head (1),
it being possible for the gripper (3) to be plugged onto the shaft (2) in the axial direction,
the gripper (3) having in the area of the shaft (2) a hollow cylindrical centring section (9) resting on said shaft (2),
the gripper having an annular locating groove (6) in the area of the centring section (9) or close to the latter,
the shaft (2) being provided with locating means (5) projecting radially and engaging in the locating groove (6), and
the locating means being offset axially with respect to the locating groove (6) in such a way that the gripper (3) can be pressed in the axial direction against a stop (7) of the shaft (2),
**characterized in that** the locating means are designed as peripherally distributed fixed short locating caps, which are permanently connected to the shaft (2) and engage in the flat locating groove (6).

2. Device according to Claim 1, **characterized in that** the locating caps are designed as spherical domes.

3. Device according to Claim 2, **characterized in that** the locating caps are formed on metallic locating spheres (5), which are inserted into an annular groove (4) of the shaft (2) and are fixed therein, for example by means of adhesive bonding.

4. Device according to Claim 3, **characterized in that** the locating spheres (5) are designed as steel spheres for ball bearings and are fixed in the annular groove (4) by means of casting.

5. Device according to Claim 4, **characterized in that** the annular groove (4) is lined with a sealing material of the type of silicone rubber.

6. Device according to one of the preceding claims, **characterized in that** the gripper has a socket-like annular wall (9) in a fixing area, which engages around the shaft (2) from outside, and **in that** the wall thickness of the annular wall (9) is so low that it deforms under the stress of the locating caps to form a round corner.

## Revendications

1. Dispositif de maintien d'un élément préhenseur (3) pour un composant électrique (8) sur une tête de placement (1), dans lequel l'élément préhenseur (3) peut être fixé de manière amovible au niveau d'une section d'extrémité d'une tige essentiellement cylindrique (2) de la tête de placement (1),
dans lequel l'élément préhenseur (3) peut être fixé dans la direction axiale sur la tige (2),
dans lequel l'élément préhenseur (3) dans la zone de la tige (2) présente une section de centrage en forme de cylindre creux, adjacente à celle-ci,
dans lequel l'élément préhenseur présente dans la zone de la section de centrage (9) ou proche de celle-ci, une rainure d'encliquetage de forme annulaire (6),
dans lequel la tige (2) est munie de moyens d'encliquetage (5) surmontant radialement et s'engageant dans la rainure d'encliquetage (6) et
dans lequel les moyens d'encliquetage sont décalés axialement par rapport à la rainure d'encliquetage (6) de sorte que l'élément préhenseur (3) peut être pressé dans la direction axiale contre une butée (7) de la tige (2),
**caractérisé en ce que**, les moyens d'encliquetage sont formés en tant que calottes d'encliquetage courtes, solides, distribuées à la périphérie, qui sont liées solidement à l'arbre (2) et qui s'engagent dans la rainure d'encliquetage plate (6).

2. Dispositif selon la revendication 1,
**caractérisé en ce que** les calottes d'encliquetage sont formées en tant que calottes sphériques.

3. Dispositif selon la revendication 2,
**caractérisé en ce que** les calottes d'encliquetage sont formées sur des billes d'encliquetage métalliques (5), qui sont insérées dans une rainure annulaire (4) de la tige (2) et qui y sont fixées par exemple, au moyen d'une colle.

4. Dispositif selon la revendication 3,
**caractérisé en ce que** les billes d'encliquetage (5) sont formées en tant que billes d'acier pour un roulement à billes et sont fixées par scellage dans la rainure annulaire (4).

5. Dispositif selon la revendication 4,
**caractérisé en ce que** la rainure annulaire (4) est garnie d'une matière d'étanchéité du type caoutchouc siliconé.

6. Dispositif selon l'une quelconque des revendications précédentes,
**caractérisé en ce que** l'élément préhenseur présente dans une zone de consolidation, une paroi annulaire du type douille (9), qui entoure la tige (2) depuis l'extérieur, et **en ce que** l'épaisseur de paroi de la paroi annulaire (9) est tellement faible que celle-ci se déforme en un coin arrondi sous la contrainte des calottes d'encliquetage.
